Europäisches Patentamt

**European Patent Office**

Office européen des brevets

(11) Publication number: **0 146 330**
A2

(12) **EUROPEAN PATENT APPLICATION**

(21) Application number: **84308592.9**

(22) Date of filing: **11.12.84**

(51) Int. Cl.⁴: **H 01 L 23/48**

(30) Priority: **12.12.83 US 560766**

(43) Date of publication of application: **26.06.85**
**Bulletin 85/26**

(84) Designated Contracting States: **DE FR GB**

(71) Applicant: **TEXAS INSTRUMENTS INCORPORATED,**
**13500 North Central Expressway, Dallas**
**Texas 75265 (US)**

(72) Inventor: **Orcutt, John W., 3210 Collins Blvd., Garland,**
**TX 75042 (US)**

(74) Representative: **Abbott, David John et al, Abel & Imray**
**Northumberland House 303-306 High Holborn, London,**
**WC1V 7LH (GB)**

(54) Integrated circuit device with textured bar pad.

(57) A semiconductor integrated circuit device (10) includes a bar pad (14) to which a semiconductor bar (12) is affixed. The lower surface (18) of the bar pad (14) is textured (20) to mechanically lock the bar pad (14) to the encapsulating medium (16).

ACTORUM AG

-1-

INTEGRATED CIRCUIT DEVICE WITH TEXTURED BAR PAD

BACKGROUND OF THE INVENTION

The present invention relates generally to semiconductor integrated circuit (IC) devices, and more particularly to an IC device including a textured bar pad.

As semiconductor IC bars increase in size, the packaging of the bars becomes more important in determining the integrity and reliability of the completed devices. One problem associated with large bars, particularly those encapsulated in plastic, is the thermal expansion stress exerted on the bar by the plastic package. The plastic and the bar and bar pad expand and contract at different rates, which can cause a shear force at the periphery of the bar. This stress can bow the package and cause the plastic to delaminate from the bar pad, which can in turn crack or otherwise damage the plastic. This is particularly evident during temperature cycling of the completed devices.

SUMMARY OF THE INVENTION

Accordingly, the present invention overcomes many of the aforementioned disadvantages by providing a semiconductor device including a bar pad having a textured lower surface.

In one embodiment of the invention the lower surface of the bar pad, that is, the surface opposite the one to which a semiconductor bar is affixed, is chemically, mechanically or otherwise textured to form irregularities which lock the bar pad to the encapsulating medium, thus minimizing the adverse effects of thermal expansion stresses.

BRIEF DESCRIPTION OF THE DRAWINGS

Other objects and many of the attendant advantages of the present invention will become apparent, and the invention will be better understood by reference to the following detailed description with the accompanying drawings, wherein:

FIG. 1 is a cross-sectional view of a semiconductor integrated circuit device including the textured bar pad of the present invention;

FIG. 2 is a bottom plan view of the bar pad of FIG. 1; and

FIG. 3 is a bottom plan view of the semiconductor device of FIG. 1 showing an alternate means of bar pad texturing.

0146330

-3-

## DETAILED DESCRIPTION OF THE PREFERRED EMBODIMENT

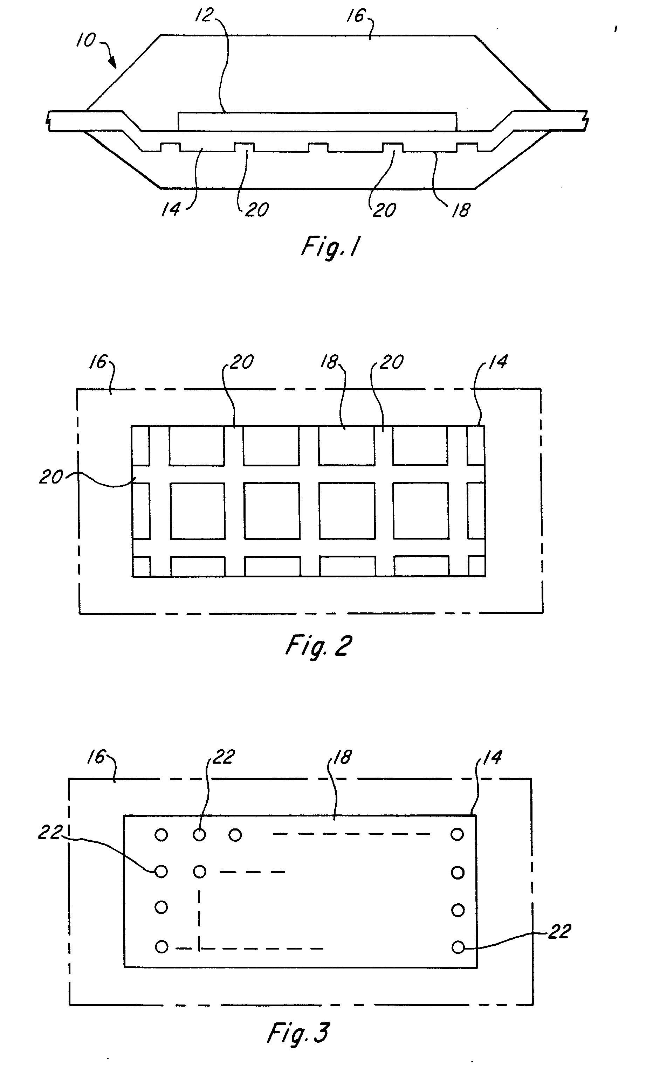

Referring now to the drawings, there is shown in FIG. 1 a completed integrated circuit device 10 which includes a semiconductor bar 12 having active devices formed in the upper surface thereof. Bar 12 is affixed to the upper surface of a bar pad 14, which during fabrication is normally a part of a matrix (not shown) of a plurality of other bar pads. The bar pad 14 is typically formed of copper or other conductive material, and the bar pad 14 and bar 12 are contained within an encapsulating medium or package 16, for example an epoxy plastic, to form the completed device 10. According to one embodiment of the present invention, the lower surface 18 of bar pad 14, that is, the surface opposite the one to which bar 12 is affixed, is textured or made irregular by a pattern of grooves 20 or depressions formed therein. One such pattern, shown in FIG. 2, is formed by two sets of spaced apart grooves 20 perpendicular to each other to create a "waffled" pattern. This has the effect of mechanically locking the plastic or other encapsulating medium to the bar pad and distributing the thermal shear stress over the entire bar pad 14, thus significantly reducing the possibility of delamination or separation of the plastic from the pad. The pattern shown in FIG. 2 may be formed, for example, by conventional resist patterning followed by chemical etching, by stamping, or by sawing.

-4-

It has been found that the aforementioned delamination problem is minimized by various forms of texturing or roughening of surface 18 other than the pattern shown in FIG. 2. For example, the unpatterned chemical etching or sandblasting of surface 18 has produced results similar to those achieved with the pattern of FIG. 2.

Another means of texturing surface 18 of bar pad 14 is shown in FIG. 3, wherein a plurality of spaced apart circular openings 22 are formed therein extending into the surface of pad 14, for example, about 1-3 mils. In this embodiment, as well as the embodiment shown in FIG. 2, the pattern of openings 22 may be asymmetric so that the openings 22 are closer together near the outer edge of pad 14. In this manner the areas of greater stress will be more securely locked to the package 16.

The present invention thus provides an improved IC packaging structure that overcomes the delamination problems resulting from differential thermal expansion or other stresses.

Other embodiments and modifications of the present invention will readily come to those skilled in the art having the benefit of the foregoing description and drawings. It is therefore to be understood that such modifications and embodiments are intended to fall within the spirit and scope of the appended claims.

CLAIMS

1. An integrated circuit device comprising:

a semiconductor bar;

a bar pad having first and second surfaces, said semiconductor bar being affixed to said first surface of said bar pad, and said second surface of said bar pad being textured;

and an encapsulating medium surrounding said semiconductor bar and at least a portion of said bar pad, mechanically locked to said textured surface to distribute thermal shear stress over the bar pad.

2. The integrated circuit device of claim 1 wherein said textured second surface of said bar pad includes a plurality of spaced apart grooves formed therein.

3. The integrated circuit device of claim 1 wherein said textured second surface of said bar pad is pebbled.

4. The integrated circuit device of claim 1 wherein said textured second surface of said bar pad includes a plurality of spaced apart cavities formed therein.

5. An integrated circuit device comprising:

a semiconductor integrated circuit bar;

support means having an upper surface and a lower surface, said semiconductor integrated circuit bar being affixed to said upper surface and said lower surface being textured; and

packaging means encapsulating said integrated circuit bar and said support means, mechanically locked to said textured surface to distribute thermal shear stress over the support means.

6. The integrated circuit device of claim 5 wherein said packaging means comprises plastic.

7. The integrated circuit device of claim 6 wherein said textured second surface of said bar pad includes a plurality of spaced apart grooves formed therein.

8. The integrated circuit device of claim 6 wherein said textured second surface of said bar pad is pebbled.

9. The integrated circuit device of claim 6 wherein said textured second surface of said bar pad includes a plurality of spaced apart cavities formed therein.

Fig.1

Fig. 2

Fig.3